# EUROPÄISCHE PATENTSCHRIFT

(11) **EP 0 487 783 B1**
(45) Veröffentlichungstag und Bekanntmachung des Hinweises auf die Patenterteilung: **05.02.1997**
(21) Anmeldenummer: 90123007.8
(22) Anmeldetag: 30.11.1990
(51) Int. Cl.: H03H 9/25

(54) **Oberflächenwellen-Resonator**
Surface wave resonator
Résonateur à ondes de surface

(43) Veröffentlichungstag der Anmeldung: 03.06.1992
(73) Patentinhaber: SIEMENS MATSUSHITA COMPONENTS GmbH & CO KG, 81541 München (DE)
(72) Erfinder: Fleischmann, Bernd, Dipl.-Ing., W-8000 München 71 (DE)
(74) Vertreter: Fuchs, Franz-Josef, Dr.-Ing.

(56) Entgegenhaltungen:
- US-A- 4 028 648
- MIROWAVE JOURNAL, Band 19, Nr. 9, September 1976, Seiten 43-46, Dedham, US; W. H. HAYDL: "Surface acoustic wave resonators"
- IDEM

## Beschreibung

Die Erfindung betrifft einen Oberflächenwellen-Resonator mit einem Substrat aus piezoelektrischem Werkstoff, und mit auf die eine Substratseite aufgebrachten Reflektoren, zwischen denen sich Ein- und Ausgangswandler, d.h. sogenannte Interdigitalwandler befinden.

Ein geeignetes Substratmaterial ist Lithiumniobat, Lithiumtantalat und wegen seiner Temperaturstabilität insbesondere Quarz. Je nach Kristallschnitt und Ausbreitungsrichtung der Welle im Substrat kommt die Rayleigh- oder Oberflächenscherwelle zur Anwendung.

Die Wandler sind sogenannte Interdigitalwandler und bestehen aus metallischen, alternierend angeordneten Elektrodenfingern, welche jeweils an Sammelelektroden bzw. Busbars unterschiedlicher Polarität liegen und üblicherweise so gestaltet sind, daß sie im Bereich um die Resonanzfrequenz des Oszillators die Oberflächenwelle nur wenig reflektieren, obgleich Ausführungen mit teilweise reflektierenden, z.B. dispersiven Wandlern unter Umständen Vorteile bieten können.

Die Reflektoren der Oberflächenwellen-Resonatoren bestehen üblicherweise aus - betrachtet in Ausbreitungsrichtung der Oberflächenwellen - senkrecht zu den Oberflächenwellen gerichteten und parallel zueinander sowie im gleichen Abstand angeordneten streifenförmigen metallischen Einzelelementen, gegebenenfalls auch aus entsprechend aus dem Substrat herausgearbeiteten Nuten (siehe z.B. "Surface Wave Filters", Verf. Herbert Matthews; Hrsg. John Wiley and Sons, New York. London. Sydney. Toronto 1977, S. 412 - 440). Während die beiden äußeren Reflektoren R5 bzw. R6 - siehe z.B. den in Figur 2 schematisch dargestellten Oberflächenwellen-Resonator 1 - praktisch die gesamte auf diese Reflektoren auflaufende Oberflächenwellenenergie reflektieren, was zur Erzielung einer hohen Güte wichtig ist, ist, falls zusätzlich ein mittlerer, d.h. zwischen den beiden Wandlern IDW5 und IDW6 angeordneter Reflektor vorgesehen ist, dieser für die auftreffende Oberflächenwellenenergie teildurchlässig.

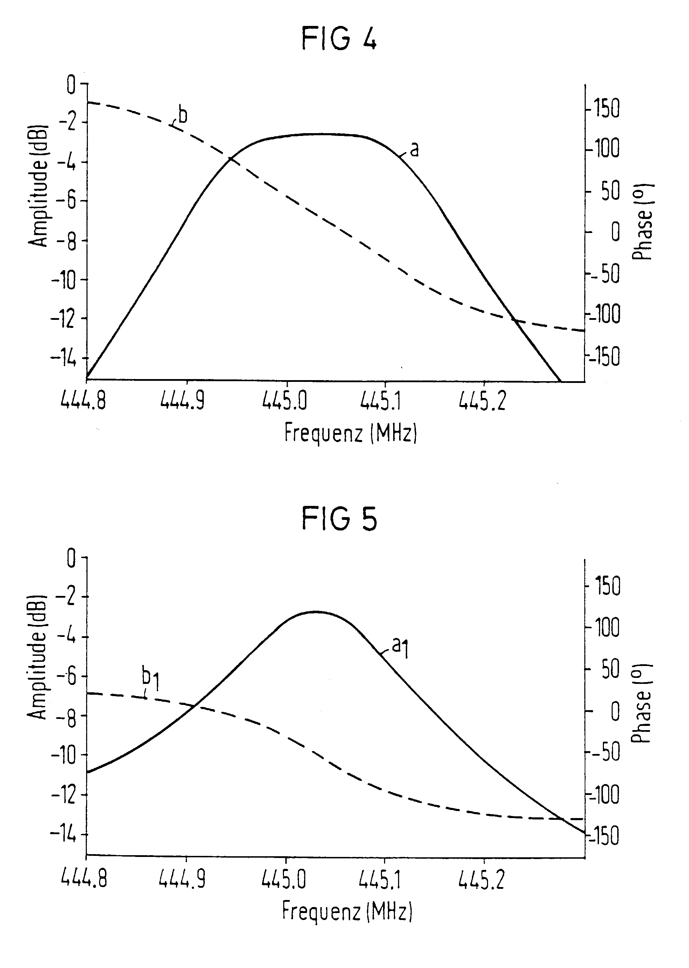

Durch geeignete Dimensionierung der Teilstrukturen der Wandler und Reflektoren unter Berücksichtigung parasitärer Elemente wie z.B. Zuführungsinduktivitäten und -widerstände kann eine Ubertragungsfunktion erzielt werden, wie sie z.B. in Figur 5 dargestellt ist, in der Betrag und Phase eines einpoligen Resonators z.B. gemäß Figur 2 aufgezeichnet sind.

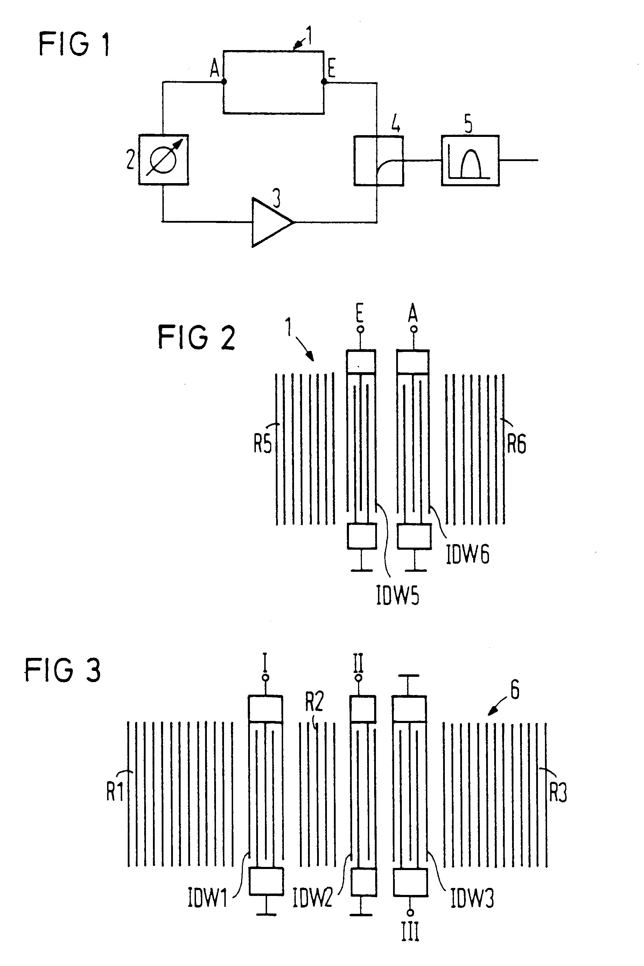

In Oszillatoren, die aufgrund ihrer guten Eigenschaften und geringen Kosten einen einpoligen Oberflächenwellen-Resonator 1 (siehe Figur 1 und 2), im folgenden kurz OFW-Resonator genannt, zur Stabilisierung der Schwingfrequenz im Oszillator verwenden, erfolgt die Signalauskopplung bisher in einem gesonderten Schaltungsteil 4. Es gibt mehrere Schaltungsvarianten, welche diese Funktion der Signalauskopplung übernehmen können. Sie haben unterschiedliche Vor- und Nachteile; gemeinsam ist ihnen, daß sie im Oszillatorsignal befindliche Störanteile, wie z.B. die zweite Harmonische des Nutzsignals, kaum unterdrücken. Deshalb ist häufig eine nachträgliche Filterung des ausgekoppelten Signals durch ein der Auskopplungsschaltung 4 nachgeschaltetes Filterelement 5 notwendig.

Bei der für Oszillatoren häufig verwendeten und in Figur 1 im Blockschaltbild dargestellten Pierce-Schaltung befindet sich der, im übrigen in Figur 2 eingehender dargestellte, einpolige OFW-Resonator in der Rückkoppelschleife eines Verstärkers 3. Das Phasenstellglied 2 dient dazu, die Phasenbedingungen für die Oszillation - die Gesamtphase muß ein ganzzahliges Vielfaches von 2 π betragen - bei der Resonatormittenfrequenz zu gewährleisten. Die gezeigte Pierce-Schaltung hat sich als besonders vorteilhaft im UHF-Bereich ab 300 Megahertz erwiesen.

Aus einem Artikel von W.H. HAYDL, "Surface acoustic wave resonators", in Microwave Journal, Band 19, Nr. 9, September 1976, Seiten 43-46, ist ein Oberflächenwellen-Resonator mit drei elektrischen Toren und dessen Verwendung in einem Oszillator bekannt.

Der vorliegenden Erfindung liegt die Aufgabe zugrunde, einen OFW-Resonator zu schaffen, der in besonders einfacher und ausgezeichneter Weise die Stabilisierung der Schwingfrequenz in einem Oszillator und das Problem der Signalauskopplung aus dem Oszillator löst und dabei gleichzeitig den Anteil an Störsignalen im Ausgangssignal reduziert.

Darüber hinaus soll der OFW-Resonator auch für weitere Anwendungen geeignet sein, z.B. als Leistungsteiler und in umgekehrter Weise als Additionselement für getrennten Eingangswandlern des OFW-Resonators zugeführte Signale.

Zur Lösung dieser Aufgabe sieht die Erfindung bei einem OFW-Resonator mit drei elektrischen Toren gemäß Oberbegriff des Patentanspruchs vor, daß zwischen den beiden Reflektoren des OFW-Resonators mindestens ein weiterer zwischen den Wandlern angeordneter Reflektor vorgesehen ist, der die auftreffende Oberflächenwellenenergie nur zu einem Bruchteil reflektiert.

Dieser kurz als OFW-Dreitor-Resonatorfilter bezeichnete Resonator faßt bei seinem Einsatz im Oszillator die in einer Oszillatorschaltung gemäß Figur 1 getrennten Elementen zugeordneten Funktionen Frequenzstabilisierung, Signalauskopplung und -filterung sowie Phasenstellung in einem einzigen Bauelement zusammen, das, was seine Herstellung sehr vereinfacht, mit den üblichen Fertigungsmethoden für OFW-Filter hergestellt werden kann.

Vorteilhafterweise sind dabei die an die beiden äußeren Reflektoren angrenzenden, im wesentlichen reflexionsfreien Wandlerbereiche im wesentlichen gleich groß gewählt.

Wenngleich auch gewichtete Wandler einsetzbar sind, sieht die Erfindung bevorzugt ungewichtete Interdigitalwandler, d.h. Wandler mit konstant gleicher Überlappung ihrer Elektrodenfinger unterschiedlicher Polarität vor.

Der OFW-Resonator nach der Erfindung und mögliche Anwendungen desselben sind nachstehend anhand der Figuren erläutert. Es zeigt:
- Figur 1: ein Blockschaltbild eines an sich bekannten Oszillators in sogenannter Pierce-Schaltung,
- Figur 2: in Draufsicht und schematischer Darstellung einen an sich bekannten OFW-Resonator, eingesetzt z.B. in eine Pierce-Schaltung nach Figur 1,
- Figur 3: einen zweipoligen OFW-Resonator nach der Erfindung in der Darstellung nach Figur 2,
- Figur 4: die Übertragungsfunktion (Betrag und Phase) eines zweipoligen OFW-Resonators nach Figur 3,
- Figur 5: die Übertragungsfunktion (Betrag und Phase) eines einpoligen OFW-Resonators nach Figur 2,
- Figur 6: das Blockschaltbild eines mit einem OFW-Resonator nach der Erfindung ausgerüsteten Oszillators,
- Figur 7: einen Oszillator mit einem OFW-Resonator nach Figur 3, dessen Oszillatorfrequenz durch eine variable Abschlußimpedanz steuerbar ist,
- Figur 8: den OFW-Resonator nach Figur 3, der durch entsprechende Ansteuerung als Leistungsteiler oder Additionselement vcn Signalen einsetzbar ist.

Der OFW-Resonator nach Figur 2 und der Oszillator nach Figur 1 sind bereits eingangs hinlänglich beschrieben worden, so daß sich deren nochmalige Erläuterung im wesentlichen erübrigt.

Figur 3 zeigt einen möglichen Aufbau des OFW-Resonators 6 nach der Erfindung, der aus drei Interdigitalwandlern IDW1, IDW2, IDW3 mit entsprechenden Eingängen I, II und III und in seiner einfachsten Ausführungsform aus zwei Reflektoren R1 und R3 besteht, wobei erforderlichenfalls weitere Reflektoren, jedoch mindestens der Reflektor R2, zwischen diesen und zwischen den Interdigitalwandlern angeordnet sein können.

Durch entsprechende Dimensionierung der Teilstrukturen der Interdigitalwandler und der Reflektoren, die unter Berücksichtigung parasitärer Elemente, wie z.B. Zuführungsinduktivitäten und -widerstände zu erfolgen hat, kann für die Übertragungsfunktion vom Punkt I zu den Punkten II und III (siehe Figur 3) die Charakteristik eines optimal gekoppelten zweipoligen OFW-Resonators erzielt werden, wie sie in Figur 4 dargestellt ist, in welcher der Verlauf der Amplitude und Phase über der Frequenz - siehe Kurve a und Kurve b - aufgetragen ist.

Geringe Abweichungen in der Dimensionierung der Teilstrukturen der Wandler und Reflektoren sowie in der Bemessung der parasitären Elemente von der optimalen Kopplung sind dabei zulässig; sie beeinträchtigen nicht unbedingt die Funktion des OFW-Resonators.

Zum Vergleich zur Übertragungscharakteristik des OFW-Filters 6 nach Figur 3 zeigt Figur 5 die Übertragungsfunktion eines einpoligen OFW-Resonators nach Figur 2 - siehe hierzu den Verlauf der Amplitude und der Phase über der Frequenz, wie er durch die Kurven a₁ und b₁ wiedergegeben wird.

Die aus diesen Übertragungsfunktionen erkennbaren wesentlichen Unterschiede zwischen den in Vergleich stehenden OFW-Resonatoren sind die größere Bandbreite und der größere Bereich linearen Phasengangs des zweipoligen OFW-Resonators bei praktisch gleicher Phasensteilheit und damit auch gleicher Güte. Das ermöglicht es, die Übertragungsfunktion so zu entwerfen, daß bei der Soll-Schwingfrequenz eines Oszillators die Phase den zur Erfüllung der Schwingbedingungen nötigen Wert hat und die Dämpfung nur unwesentlich vom Minimum abweicht. Damit entfällt die Notwendigkeit eines z.B. bei einem Oszillator nach Figur 1 erforderlichen Phasenstellgliedes 2. Andererseits ist durch den linearen Phasengang eine Modulation der Oszillatorfrequenz, falls erforderlich, mittels eines elektronischen Phasenschiebers besser realisierbar als bei einem einpoligen OFW-Resonator.

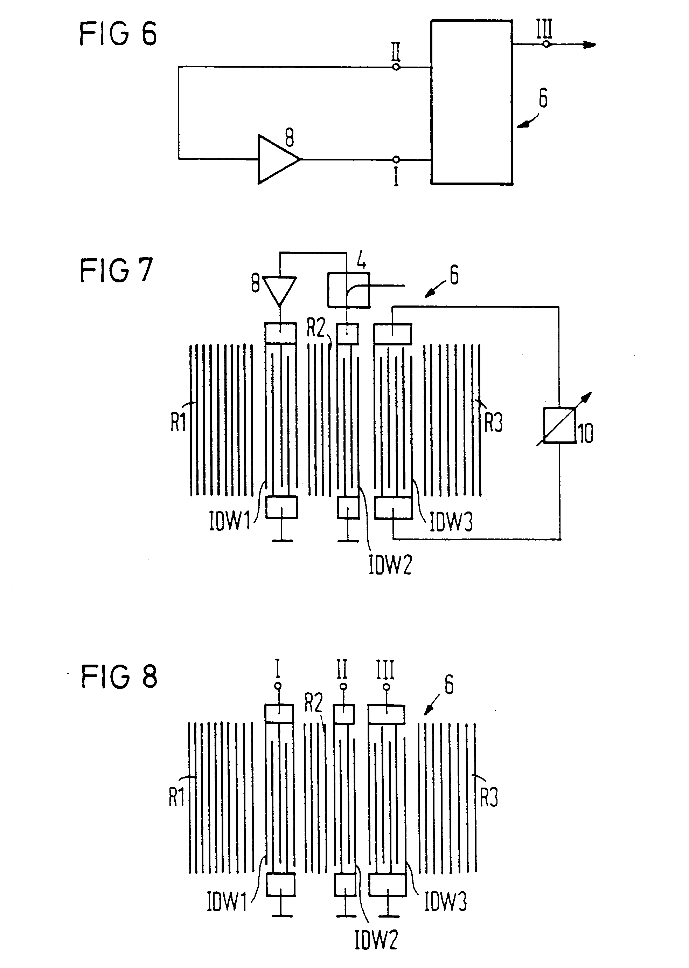

Bei dem in Figur 6 gezeigten Blockschaltbild eines Oszillators mit einem OFW-Resonator 6, z.B. gemäß Figur 3, wird über den Eingang I des Interdigitalwandlers IDW1 dem Resonator elektrische Leistung vom Verstärker 8 zugeführt. Das im Interdigitalwandler IDW2 erzeugte Signal dient dabei der Rückkopplung des Verstärkers 8, womit der Oszillatorkreis geschlossen ist. Die Signalauskopplung erfolgt über den zusätzlichen Wandler IDW3. Das Ausgangssignal wird dabei entsprechend der Übertragungsfunktion zwischen den Punkten I und III gefiltert. Eine zusätzliche Filterung erübrigt sich damit in den meisten Fällen. Üblicherweise wird man so viel Leistung wie möglich auskoppeln, was bedeutet, daß man den Interdigitalwandler IDW2 so dimensioniert, daß am Eingang des Verstärkers 8 nur so viel Leistung anliegt, wie zur Aufrechterhaltung der Oszillation erforderlich ist. Der Großteil der Leistung kann dann bei entsprechender Dimensionierung über den Interdigitalwandler IDW3 aus dem Oszillatorkreis ausgekoppelt werden.

Ein weiterer Vorteil des OFW-Resonators nach der Erfindung ist, daß Rückwirkungen nachfolgender Schaltungen auf den Oszillatorkreis durch diese Art der Signalauskopplung minimiert sind.

Wird, wie dies in Figur 7 gezeigt ist, der Interdigitalwandler IDW3 durch eine in ihrer Impedanz änderbare Abschlußimpedanz 10 abgeschlossen, so läßt sich durch diese Beschaltung die Oszillatorfrequenz des Oszillators entsprechend steuern. Da hierbei der Interdigitalwandler IDW3 als Element zur Auskopplung des Oszillatorsignals entfällt, erfolgt die Signalauskopplung über das Schaltteil 4 oder über einen in der Zeichnung nicht dargestellten zusätzlichen Interdigitalwandler.

Der OFW-Resonator nach Figur 3 kann auch als Leistungsteiler oder als Additionselement für Signale dienen - siehe Figur 8.

Im erstgenannten Fall sind z.B. der Wandler IDW1 als Eingangswandler und die restlichen Wandler IDW2 und IDW3 als Ausgangswandler konzipiert, wobei die Leistungsteilung durch entsprechende Dimensionierung, z.B. entsprechende Längenverteilung der Ausgangswandler erfolgt.

Ist der OFW-Resonator 6 zur Addition von Signalen vorgesehen, so werden die Einzelsignale getrennten Wandlern, z.B. den Wandlern IDW2 und IDW3 zugeführt und über einen einzelnen Wandler, d.h. den Wandler IDW1, dem Resonator entnommen.

## Patentansprüche

1. Oberflächenwellen-Resonator mit einem Substrat aus piezoelektrischem Werkstoff und mit zwei auf die eine Substratseite aufgebrachten Reflektoren (R₁,R₃), zwischen denen sich Ein- und Ausgangswandler (IDW₁,IDW₂) befinden,
wobei der Oberflächenwellen-Resonator durch Anordnung eines zusätzlichen Wandlers (IDW3) zwischen den Reflektoren (R1, R3) zu einem Oberflächenwellen-Resonator (6) mit drei elektrischen Toren erweitert ist,
**dadurch gekennzeichnet,**
daß mindestens zwischen zwei Wandlern (IDW1, IDW2) mindestens ein Reflektor (R2) angeordnet ist, der die auftreffende Oberflächenwelle nur zu einem Bruchteil reflektiert.

2. Oberflächenwellen-Resonator nach Anspruch 1,
**dadurch gekennzeichnet,**
daß die an die beiden äußeren Reflektoren (R1, R3) angrenzenden, im wesentlichen reflexionsfreien Wandlerbereiche im wesentlichen gleich groß gewählt sind.

3. Oberflächenwellen-Resonator nach Anspruch 1,
**dadurch gekennzeichnet,**
daß die Wandler (IDW1, IDW2, IDW3) ungewichtete Interdigitalwandler sind.

4. Oberflächenwellen-Resonator nach Anspruch 1,
**dadurch gekennzeichnet,**
daß die Einzelelemente der Reflektoren (R1, R2, R3) gleiche Breite und zueinander gleichen Abstand aufweisen.

5. Oszillator, **gekennzeichnet** durch einen Oberflächenwellen-Resonator (6) nach Anspruch 1, der über zwei seiner Wandler (IDW1, IDW2) entsprechend jeweils mit einem Eingang und einem Ausgang eines Verstärkers (8) verschaltet ist (Figur 6).

6. Oberflächenwellen-Resonator nach Anspruch 1 und 5,
**dadurch gekennzeichnet,**
daß der zusätzliche Wandler (IDW3) zur Auskopplung des frequenzstabilisierten Signals aus dem Oszillator dient.

7. Oberflächenwellen-Resonator nach Anspruch 1 und 5,
**dadurch gekennzeichnet**,
daß die Oszillatorfrequenz durch Änderung der Abschlußimpedanz des zusätzlichen Wandlers (IDW3) steuerbar ist (Figur 7).

8. Oberflächenwellen-Resonator nach Anspruch 1 und 7,
**dadurch gekennzeichnet,**
daß zur Auskopplung des frequenzstabilisierten Signals aus dem Oszillator ein vierter Wandler vorgesehen ist.

9. Oberflächenwellen-Resonator nach Anspruch 1,
**dadurch gekennzeichnet,**
daß der Resonator (6) als Leistungsteiler ausgebildet ist, dessen einer Wandler (IDW1) als Eingangswandler und dessen andere Wandler (IDW2, IDW3) als Ausgangswandler dienen und die Leistungsteilung durch entsprechende Dimensionierung der Wandler erfolgt (Figur 8).

10. Oberflächenwellen-Resonator nach Anspruch 1,
**dadurch gekennzeichnet**,
daß der Resonator (6) zur Addition von Signalen vorgesehen ist, wobei die zur Addition bestimmten Signale getrennten Wandlern (IDW2, IDW3) zugeführt und über einen einzelnen Wandler (IDW1) dem Resonator entnommen werden (Figur 8).

## Claims

1. Surface acoustic wave resonator having a substrate composed of piezoelectric material and having two reflectors (R1, R3) which are fitted onto one side of the substrate and between which input and output transducers (IDW1, IDW2) are located, the surface acoustic wave resonator being extended by the arrangement of an additional transducer (IDW3) between the reflectors (R1, R3) to form a surface acoustic wave resonator (6) having three electrical ports, characterized in that at least one reflector (R2) is arranged at least between two transducers (IDW1, IDW2), which reflector (R2) reflects only a fraction of the incident surface acoustic wave.

2. Surface acoustic wave resonator according to Claim 1, characterized in that the transducer areas which are adjacent to the two outer reflectors (R1, R3) and are essentially reflection-free are essentially chosen to be the same size.

3. Surface acoustic wave resonator according to Claim 1, characterized in that the transducers (IDW1, IDW2, IDW3) are unweighted interdigital transducers.

4. Surface acoustic wave resonator according to Claim 1, characterized in that the individual elements of the reflectors (R1, R2, R3) have the same width and are at the same distance from one another.

5. Oscillator, characterized by a surface acoustic wave resonator (6) according to Claim 1, which is connected appropriately via two of its transducers (IDW1, IDW2) in each case to an input and to an output of an amplifier (8) (Figure 6).

6. Surface acoustic wave resonator according to Claims 1 and 5, characterized in that the additional transducer (IDW3) is used to extract the frequency-stabilized signal from the oscillator.

7. Surface acoustic wave resonator according to Claims 1 and 5, characterized in that the oscillator frequency can be controlled by varying the termination impedance of the additional transducer (IDW3) (Figure 7).

8. Surface acoustic wave resonator according to Claims 1 and 7, characterized in that a fourth transducer is provided for extraction of the frequency-stabilized signal from the oscillator.

9. Surface acoustic wave resonator according to Claim 1, characterized in that the resonator (6) is designed as a power splitter, one transducer (IDW1) of which is used as the input transducer and the other transducers (IDW2, IDW3) of which are used as output transducers, and the power splitting is carried out by appropriate design of the transducers (Figure 8).

10. Surface acoustic wave resonator according to Claim 1, characterized in that the resonator (6) is provided for addition of signals, the signals which are intended for addition being fed to separate transducers (IDW2, IDW3) and being taken from the resonator via a single transducer (IDW1) (Figure 8).

## Revendications

1. Résonateur à ondes de surface ayant un substrat constitué en d'un matériau piézoélectrique et ayant deux réflecteurs (R1, R3) qui sont agencés sur une des faces du substrat et entre lesquels se trouvent des transducteurs d'entrée et de sortie (IDW1, IDW2), le résonateur à ondes de surface étant complété par la disposition d'un transducteur supplémentaire (IDW3) entre les réflecteurs (R1, R3) pour former un résonateur à ondes de surface (6) ayant trois portes électriques,
caractérisé par le fait que,
au moins entre deux transducteurs (IDW1, IDW2), est disposé au moins un réflecteur (R2) qui réfléchit seulement une fraction de l'onde de surface incidente.

2. Résonateur à ondes de surface selon la revendication 1,
caractérisé par le fait que
les zones de transducteurs, qui sont contiguës aux deux réflecteurs externes (R1, R3) et qui sont globalement non réfléchissantes, sont choisies de tailles sensiblement identiques.

3. Résonateur à ondes de surface selon la revendication 1,
caractérisé par le fait que
les transducteurs (IDW1, IDW2, IDW3) sont des transducteurs interdigitaux non pondérés.

4. Résonateur à ondes de surface selon la revendication 1,
caractérisé par le fait que
les éléments simples des réflecteurs (R1, R2, R3) ont la même largeur et sont à égale distance les uns des autres.

5. Oscillateur
caractérisé par
un résonateur à ondes de surface (6) selon la revendication 1 qui est branché par l'intermédiaire de deux de ses transducteurs (IDW1, IDW2) respectivement à une entrée et une sortie d'un amplificateur (8) (figure 6).

6. Résonateur à ondes de surface selon la revendication 1 et 5,
caractérisé par le fait que
le transducteur supplémentaire (IDW3) sert à la sortie du signal, stabilisé en fréquence, de l'oscillateur.

7. Résonateur à ondes de surface selon la revendication 1 et 5,
caractérisé par le fait que
la fréquence de l'oscillateur peut être commandée au moyen d'une modification de l'impédance terminale du transducteur supplémentaire (IDW3) (figure 7).

8. Résonateur à ondes de surface selon la revendication 1 et 7,
caractérisé par le fait que
un quatrième transducteur est prévu pour la sortie du signal, stabilisé en fréquence, de l'oscillateur.

9. Résonateur à ondes de surface selon la revendication 1,
caractérisé par le fait que
le résonateur (6) est conçu comme diviseur de puissance, dont un transducteur (IDW1) sert de transducteur d'entrée et dont les autres transducteurs (IDW2, IDW3) servent de transducteurs de sortie, et que la division de puissance s'effectue au moyen d'un dimensionnement adéquat des transducteurs (figure 8).

10. Résonateur à ondes de surface selon la revendication 1,
caractérisé par le fait que
le résonateur (6) est prévu pour l'addition de signaux, les signaux déterminés pour l'addition étant envoyés à des transducteurs distincts (IDW2, IDW3) et étant extraits du résonateur par l'intermédiaire d'un seul transducteur (IDW1) (figure 8).
